# EUROPEAN PATENT SPECIFICATION

(11) **EP 1 167 574 B1**
(45) Date of publication and mention of the grant of the patent: **02.07.2008**
(21) Application number: 00900373.2
(22) Date of filing: 13.01.2000
(51) Int. Cl.: C23C 30/00

(54) **METAL MATERIAL HAVING FORMED THEREON CHROMIUM OXIDE PASSIVE FILM AND METHOD FOR PRODUCING THE SAME, AND PARTS CONTACTING WITH FLUID AND SYSTEM FOR SUPPLYING FLUID AND EXHAUSTING GAS**
METALLMATERIAL MIT DARAUF GEFORMTEN PASSIVEN CHROMOXIDFILM UND VERFAHREN ZU DESSEN HERSTELLUNG, UND TEILE, DIE IN KONTAKT MIT FLÜSSIGKEIT STEHEN UND SYSTEM ZUM ZUFÜHREN VON FLÜSSIGKEIT UND ABGAS
MATERIAU METALLIQUE REVETU D'UN FILM PASSIF D'OXYDE DE CHROME, PROCEDE DE PRODUCTION ASSOCIE, ELEMENTS EN CONTACT AVEC UN FLUIDE ET SYSTEME DE TRANSPORT POUR FLUIDE ET GAZ D'ECHAPPEMENT

(30) Priority: 13.01.1999 JP 709299
(43) Date of publication of application: 02.01.2002
(73) Proprietor: FUJIKIN Inc., Osaka-shi, Osaka 550-0012 (JP); Ohmi, Tadahiro, Sendai-shi, Miyagi-ken 980-0813 (JP)
(72) Inventor: OHMI, Tadahiro, Sendai-shi, Miyagi 980-0813 (JP); SHIRAI, Yasuyuki, Chisan-Mans. Yagiyamakasumi-cho, Sendai-shi, Miyagi 982 (JP); IKEDA, Nobukazu, Fujikin Inc., Osaka-shi, Osaka 550-0012 (JP); IDETA, Eiji, Fujikin Inc., Osaka-shi, Osaka 550-0012 (JP); MORIMOTO, Akihiro, Fujikin Inc., Osaka-shi, Osaka 550-0012 (JP); OGUSHI, Tetsutaro, Nippon Kinzoku Co., Ltd., Tokyo 108-0014 (JP); KONISHI, Takehisa, Nippon Kinzoku Co., Ltd., Tokyo 108-0014 (JP)
(74) Representative: Dr. Weitzel & Partner
(86) International application number: PCT/JP2000/000133
(87) International publication number: WO 2000/042239

(56) References cited:
- JP-A- 7 180 088
- US-A- 5 164 270
- US-A- 5 597 109

## Description

Metal material having formed thereon chromium oxide passive film and method for producing the same, and parts contacting with fluid and system for supplying fluid and exhausting gas

### Technical Field of the Invention

The present invention relates to metallic material on which a chromium-oxide passivation film is formed and a method for manufacturing the same, and a fluid supplying / exhaust system.

### Background Art

In semiconductor manufacturing technology, gases with a hard corrosive action such as hydrogen chloride or hydrogen bromide or gases with a hard decomposing action such as silane, diborane, phosphine or the like have been used. Since the gases hard in corrosivity easily corrode usually used stainless steel (SUS 316L) to result in metal contamination due to corrosion on a semiconductor substrate, a semiconductor with high reliability has been difficult to manufacture.

Moreover, since the gases with the hard decomposing action are decomposed easily due to nickel hard in catalytic action on the stainless steel, and desired gases are difficult to supply with a desired concentration, the semiconductor high in reliability has been difficult to manufacture. In recent years, a technology for forming a chromium-oxide passivation film has been introduced in order to solve the problems described above.

However, a development of the metallic material, and a surface treatment technology prior to oxidizing treatment or various technologies such as a technology for supplying an oxidizing atmosphere such as temperature and a component ratio in oxidizing gases have been required in order to form the chromium-oxide passivation film. Therefore, it has been impossible to form the chromium-oxide passivation film onto the optional metallic material and parts inexpensively.

Moreover, although it has been a technology coating chromium for improvement of corrosion resistance according to the prior art, it has been not excellent since it is poor in adhesion, moreover, chromium has a large internal stress, crack is caused, so that corrosion is caused at an interface between the metallic material and the coat film. Although a crack-free chromium coating technology has been developed in order to solve these crack, fracture due to distortion at processing are caused since a film thickness is thicken excessively, thereby corrosion being caused.

Moreover, there has been problem that although a dual-layers chromium coating technology has been developed in order to solve this fracture due to distortion, this technology also is different each other in coating processes and results in an increase in cost, so that it is poor in productivity.

Moreover, there has been a technology that heat treatment is performed after metal coating. However, there have been problems in these technologies that vacancies (pin holes) exist on the surface after coating, the coat film is peeled off, or the film obtained after heat treatment is a composite-oxide film or has a property of ceramic, and since the metal material of the substrate layer is contact with corrosive gases when vacancies exist, corrosion progresses on the interface between the metal of the substrate layer and the coat film, and the desired corrosion resistance can not be obtained because of the composite-oxide film, furthermore, it is poor in workability because of the property of ceramic.

The object of the invention is to provide metallic material on which the chromium-oxide passivation film high in productivity is formed and a method for manufacturing the same by forming the chromium-oxide passivation film excellent in corrosion resistance inexpensively and in a short time.

The object of the invention is to provide the parts contacting with fluid and a fluid supplying system capable of supplying safely fluid hard in corrosivity by forming the chromium-oxide film excellent in corrosion resistance without containing an oxide film of other metal.

### Disclosure of the Invention

The metallic material according to the invention on which the chromium-oxide passivation is formed comprises the passivation film consisting of the chromium oxide obtained by oxidizing the chromium coat on the metallic material of which surface roughness (Ra) is not more than 1.5µm.

A method for manufacturing the metallic material according to the invention on which the chromium-oxide passivation is formed comprises a step of forming the passivation film consisting of the chromium oxide by applying heat treatment in an oxidizing atmosphere after coating chromium on the metallic material of which surface roughness (Ra) of a coat surface is not more than 1.5µm.

Parts contacting with fluid and a fluid supplying / exhaust system according to the invention are characterized by that these are constituted by the metallic material on which the chromium-oxide passivation film having the passivation film consisting of the chromium oxide obtained by oxidizing the chromium coat are formed on the metallic material of which surface roughness (Ra) is not more than 1.5µm.

### Brief Description of the Drawings

Fig. 1 is a schematic view of a gas supplying system used in a chromium-oxide passivation film according to the invention.
Fig. 2 is a view showing a result by evaluating chromium-oxide passivation film after oxidizing treatment by photoelectron spectroscopy.
Fig. 3 is a view showing results by evaluating surface roughness (Ra) dependence of corrosion resistance of the chromium-oxide passivation film according to the invention by SEM observation.
Fig. 4 is a view showing results by SEM observation of the sample after corrosion test by chlorine gas of sample by using a method for manufacturing the chromium-oxide passivation film according to the invention and sample which oxidizing treatment is not given, and sample after cleaning with ultra pure water after corrosion test.

### (Explanations of Characters)

- 101: flow-rate adjustment device
- 102: fluid control valve
- 103: reaction chamber

### Best Mode for Carrying out the Invention

This invention comprises a step of forming a passivation film consisting of chromium oxide excellent in corrosion resistance on an optional metallic material by giving heat treatment in an oxidizing atmosphere on a surface obtained by coating chromium onto the metallic material (for example, copper material) of which surface roughness (Ra) is not more than 1.5µm.

In the invention, a contact ability of an interface between the metallic material and a coat film is improved by coating chromium onto the metallic material of which surface roughness (Ra) is not more than 1.5µm, in addition, to strengthen a coupling force of the interface by applying heat treatment to solve the poorness of the conventional adhesion, and in addition, the chromium-oxide passivation film excellent in corrosion resistance can be formed by applying oxidizing treatment.

This invention comprises a step of forming the passivation film consisting of the sealed chromium oxide excellent in corrosion resistance by applying heat treatment in the oxidizing gas atmosphere on the surface of the metallic material on which chromium is coated. According to the invention, the problem of interface corrosion caused due to the presence of vacancies (pin holes) can be solved, in addition, the chromium-oxide passivation film excellent in corrosion resistance can be formed by applying oxidizing treatment.

In this invention, definition of the metallic material, definition of the shape of the parts and precise control of the oxidizing atmosphere are not required, and it becomes possible to form the chromium-oxide passivation film onto the optional metallic material and the parts inexpensively as compared to a chromium-oxide passivation treatment of the prior art. Definition of the metallic material and the shape of the parts and precise control of the oxidizing atmosphere are not required, whereby improvement in productivity can be realized.

Although there have been problems in the conventional chromium-oxide passivation treatment technology that there is a problem in production cost and productivity is poor, since the concentration of the oxidizing gas is low as is 10 ppm to several hundreds ppm, moreover, the range of the concentration also is narrow and so use of special parts for an oxidizing-gas supplying system and a special diluting technology are required in order to control the concentration precisely and monitor for control of the concentration also is required in treatment temperature, the range of the forming condition for formation of the chromium-oxide passivation film can be set widely according to the present invention, whereby the chromium-oxide passivation treatment inexpensive and high in productivity can be realized.

The chromium-oxide passivation film excellent in corrosion resistance becomes possible to form on the optional metallic material and the parts inexpensively and in a short time according to the invention, the fluid supplying system capable of supplying fluid with the hard corrosive action in safety can be constructed.

### Embodiments

Although a forming technology of a chromium-oxide passivation film as well as the parts contacting with fluid and a fluid supplying / exhaust system according to the invention will be described with reference to the drawings as described below, the invention should not be limited to these embodiments.

Although a chromium-coat film used for this experiment is deposited by a plating method, in addition thereto, deposition may be performed by coating technologies such as an ion-plating method, HIP method, a sputtering method. Deposition may be performed by two-steps forming method which is designed to form by the sputtering method initially and then to form by the plating method thereon.

Moreover, baking is preferably performed once at low temperature of 100ºC to 200 QC in high-purity inert gas atmosphere (the concentration of moisture is not more than 10 ppm) and then heat treatment is performed, when forming the chromium-coat film by a wet-type plating method.

Moreover, an annealing processing is preferably performed after heat treatment.

Moreover, austenite system stainless steel (SUS316L) was used for the metallic material to be oxidized.

### (Embodiment 1)

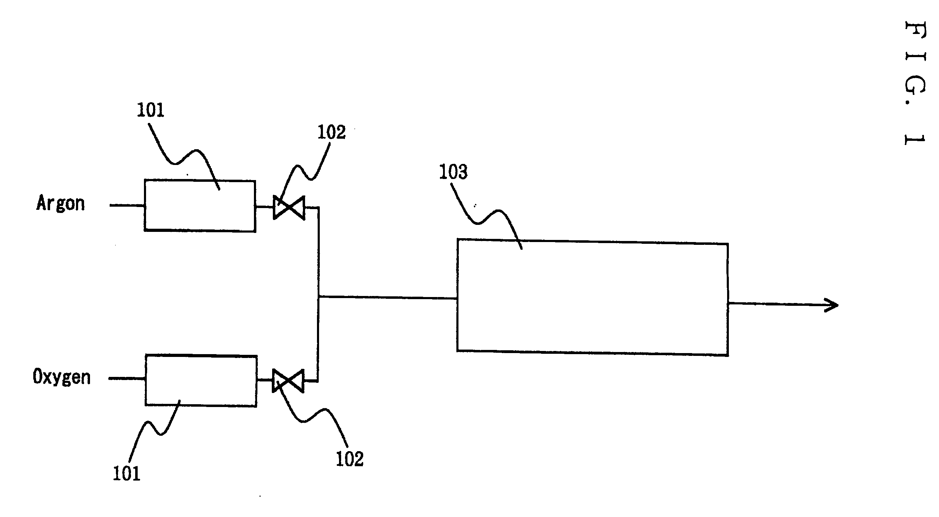

Fig. 1 is a schematic view of a gas supplying system performing treatment for the chromium-oxide passivation film according to the invention. Argon is introduced as an inert gas and oxygen as an oxidizing gas for dilution in the gas supplying system. The chromium-oxide passivation film was formed using this gas supplying system.

In this embodiment, an influence of the surface roughness (Ra) of the metallic material to be oxidized was searched by corrosion test with chlorine gas. Oxidizing conditions are 500 QC, 30 min, oxygen of 50 % (diluted by argon).

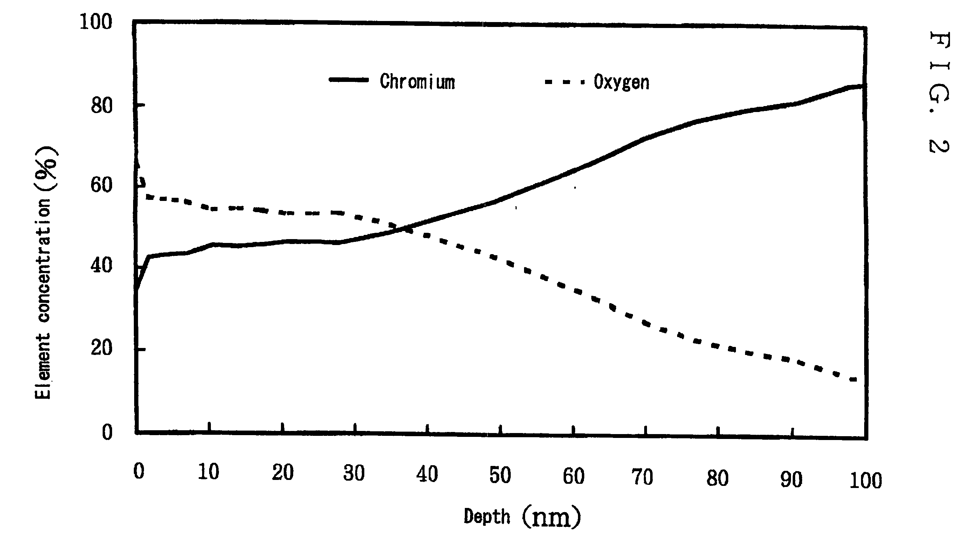

Fig. 2 shows a result measured by evaluating chromium-oxide passivation film by ESCA100, made by Shimazu Seisakusyo after oxidizing treatment.

From the results, it was verified that the chromium-oxide passivation film of substantially 100 % has been formed, which is approximately 30 nm from the outermost surface.

The corrosion test is performed under the condition of sealing chlorine gas of 100 % under not more than 5 Kgf/cm² at 100ºC for 24Hr through an accelerated test. Surface observation was performed by JSM-6401F, made by Nippon Densi Kabusikikaisya after oxidizing treatment.

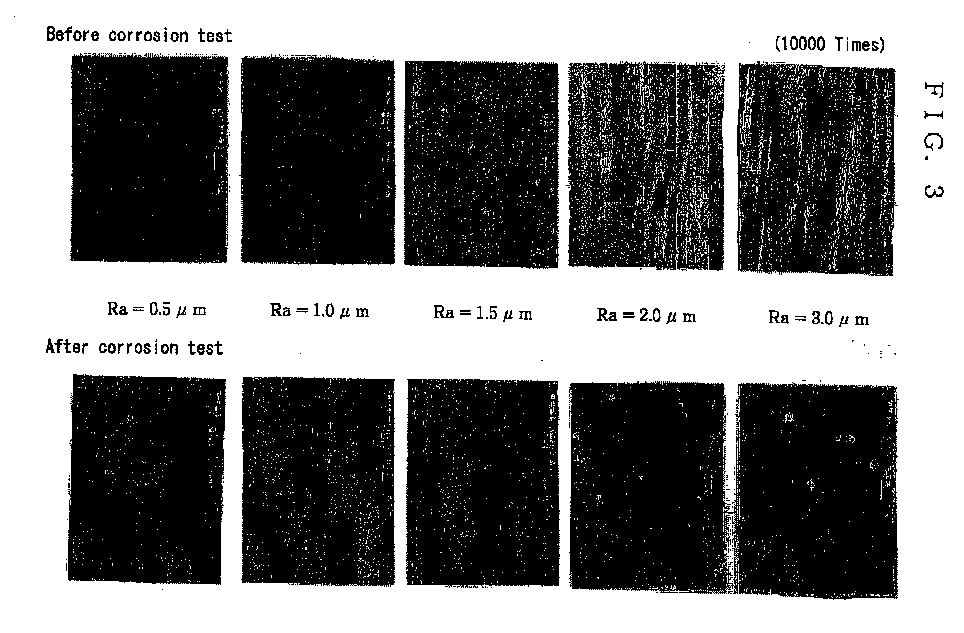

Fig. 3 shows results after the corrosion test. From the results, it was not verified that corrosive products exist in the case of the surface roughness (Ra) of not more than 1.5µm, whereas the corrosive products have been scattered in the case of not less than 2µm. It is guessed that adhesion of the interface between the metallic material and the chromium-coat film deteriorates, so that clearance corrosion is caused as the surface roughness (Ra) becomes large.

From the results as described above, it is guessed that the chromium-oxide passivation film having corrosion resistance, which is excellent in adhesion of the interface between the metallic material and the chromium-coat film can be formed when the surface roughness (Ra) of not more than 1.5µm.

Moreover, the chromium-oxide passivation film further excellent in durability can be formed by allowing to coat a metal on the metallic material to be oxidized in pretreatment for forming the chromium-coat film to improve adhesion onto chromium and to prevent crack and fracture due to distortion.

Moreover, the more close-grained and tight chromium-oxide passivation film can be formed by doping with hydrogen into the oxidizing gas.

### (Embodiment 2)

The accelerated corrosion test of the sample on which oxidizing treatment was given in the same condition as Embodiment 1 and the sample on which oxidizing treatment was not given was performed under the condition of sealing chlorine gas of 100 % under not more than 5 Kgf/cm² at 100ºC for 24Hr.

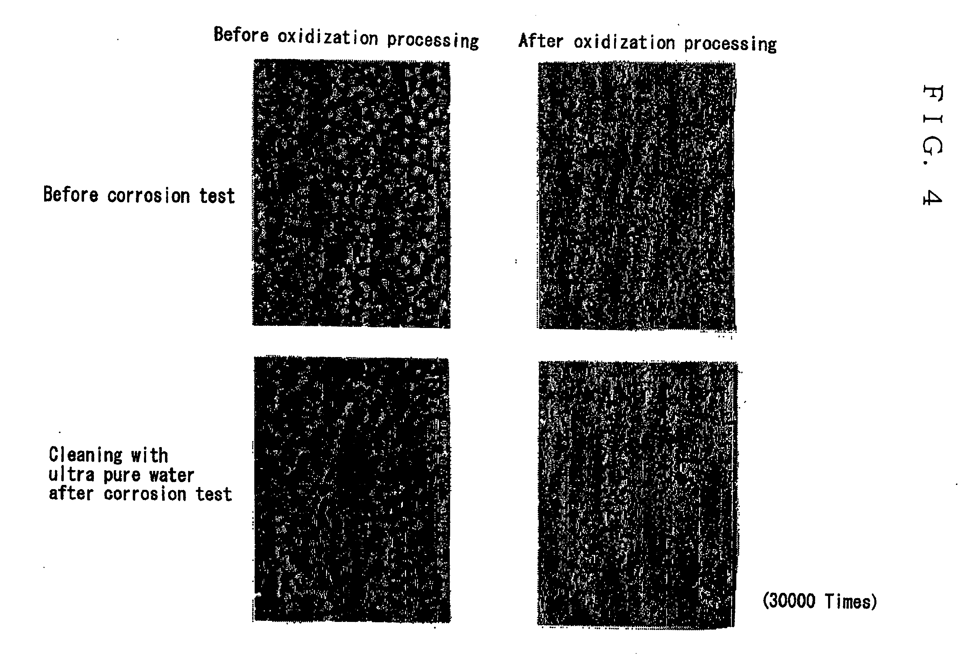

Fig. 4 shows the results by SEM observation after the corrosion test by JSM-6401F, made by Nippon Densi Kabusikikaisya after oxidizing treatment, as well as the results by SEM observation of the sample after cleaning with ultra pure water after corrosion test.

From the results, it was not verified that corrosion exist for the sample on which oxidizing treatment was given, whereas the corrosive products have been scattered for the sample on which oxidizing treatment was not given.

Moreover, it has been guessed from the results that SEM observation was performed after cleaning the sample after corrosion test with ultra pure water to remove the corrosive products or the like that changes was not observed for the sample on which oxidizing treatment was given, whereas there were the vacancies (the pin holes) of a diameter of approximately 0.1µm on the site where the corrosive products were removed for the sample on which oxidizing treatment was not given, and this was corrosion contributed to the pin holes existing after plating.

It has been found by these experiments that there are the vacancies on the coat film used for the prior art, and corrosion caused by the vacancies is progressing, however, the vacancies are filled according to the invention, whereby the chromium-oxide passivation film which is close-grained and excellent in corrosion resistance can be formed on the outermost surface.

### Applicability for the Industry

According to the present invention, the passivation film consisting of chromium oxide excellent in corrosion resistance onto the optional metallic material can be formed.

According to the present invention, the conventional problem of interface corrosion caused due to the presence of the crack, fracture due to distortion and the vacancies (pin holes) or the like can be solved, in addition, the chromium-oxide passivation film excellent in corrosion resistance can be formed by applying oxidizing treatment.

According to the present invention, definition of the metallic material, definition of the shape of the parts and precise control of the oxidizing atmosphere are not required, and it becomes possible to form the chromium-oxide passivation film onto the optional metallic material and parts inexpensively as compared to a chromium-oxide passivation treatment of the prior art, and definition of the metallic material and the shape of the parts and precise control of the oxidizing atmosphere are not required, whereby improvement in productivity is realized.

According to the invention, the fluid supplying system capable of supplying fluid with the hard corrosive action in safety can be constructed.

## Claims

1. Metallic material provided with a chromium-oxide passivation film comprising a passivation film consisting of chromium oxide obtained by oxidizing a chromium coat on the metallic material of which surface roughness (Ra) is not more than 1.5µm.

2. The metallic material provided with the chromium-oxide passivation film according to claim 1, wherein pin holes of said chromium-oxide passivation film are filled.

3. A method for manufacturing metallic material on which a chromium-oxide passivation film is formed, comprising the step of :
forming the passivation film consisting of chromium oxide by applying heat treatment in an oxidizing atmosphere after coating chromium on metallic material of which surface roughness (Ra) of a coat surface is not more than 1.5µm.

4. Parts contacting with fluid and a fluid supplying / exhaust system, comprising metallic material having a chromium-oxide passivation film according to claim 1.

## Patentansprüche

1. Metallisches Material, das mit einem Chromoxid-Passivierungsfilm versehen ist und einen aus Chromoxid bestehenden Passivierungsfilm umfasst, der durch die Oxidierung einer Chrombeschichtung auf dem metallischen Material gewonnen wurde und dessen Oberflächenrauheit (Ra) nicht mehr als 1,5 µm beträgt.

2. Metallisches Material, das mit dem Chromoxid-Passivierungsfilm gemäß Anspruch 1 versehen ist, wobei Poren des Chromoxid-Passivierungsfilms gefüllt sind.

3. Verfahren zur Herstellung von metallischem Material, auf dem ein Chromoxid-Passivierungsfilm ausgebildet ist, das folgende Schritte umfasst: Ausbildung des aus Chromoxid bestehenden Passivierungsfilms durch Anwenden einer Wärmebehandlung in einer oxidierenden Atmosphäre nach dem Aufbringen einer Chromschicht auf Metallmaterial, wobei die Oberflächenrauheit (Ra) einer Beschichtungsoberfläche nicht mehr als 1,5 µm beträgt.

4. Teile, die mit einem Fluid und einem Fluid-Zuführungs-/Abführungssystem in Kontakt gebracht werden, die metallisches Material mit einem Chromoxid-Passivierungsfilm gemäß Anspruch 1 aufweisen.

## Revendications

1. Matériau métallique doté d'un film de passivation à l'oxyde de chrome comprenant un film de passivation composé d'oxyde de chrome obtenu en oxydant un revêtement de chrome sur le matériau métallique, dont la rugosité de surface (Ra) ne dépasse pas 1,5 µm.

2. Matériau métallique doté du film de passivation à l'oxyde de chrome selon la revendication 1, dans lequel les piqûres dudit film de passivation à l'oxyde de chrome sont remplies.

3. Procédé de fabrication d'un matériau métallique sur lequel est formé un film de passivation à l'oxyde de chrome, comprenant l'étape de formation du film de passivation composé d'oxyde de chrome par application d'un traitement thermique sous une atmosphère oxydante après application de chrome sur le matériau métallique, dont la rugosité de surface (Ra) ne dépasse pas 1,5 µm.

4. Pièces venant en contact avec un liquide et système d'alimentation et évacuation de liquide, comprenant un matériau métallique doté d'un film de passivation à l'oxyde de chrome selon la revendication 1.
